# EUROPEAN PATENT APPLICATION

(11) **EP 1 780 303 A2**
(43) Date of publication of application: **02.05.2007**
(21) Application number: 06022261.9
(22) Date of filing: 25.10.2006
(51) Int. Cl.: C23C 16/515, H01J 37/32

(54) **System and method for power function ramping of microwave linear discharge sources**

(30) Priority: 01.11.2005 US 264540
(71) Applicant: Applied Films Corporation, Longmont, CO 80504 (US); Applied Materials GmbH & Co. KG, 63755 Alzenau (DE)
(72) Inventor: Stowell, Michael W., Loveland, Colorado 80538 (US); Liehr, Michael, 36325 Feldatal (DE); Wieder, Stephan, 60385 Frankfurt (DE); Dieguez-Campo, José Manuel, 63457 Hanau (DE)
(74) Representative: Schickedanz, Willi

(57) **Abstract**

One embodiment of the present invention is a system for depositing films on a substrate. This systems includes a vacuum chamber; a linear discharge tube housed inside the vacuum chamber; a magnetron configured to generate a microwave power signal that can be applied to the linear discharge tube; a power supply configured to provide a signal to the magnetron; and a pulse control connected to the power supply. The pulse control is configured to control the duty cycle of the plurality of pulses, the frequency of the plurality of pulses, and/or the contour of the plurality of pulses.

## Description

### FIELD OF THE INVENTION

The present invention relates to power supplies, systems, and methods for chemical vapor deposition.

### BACKGROUND OF THE INVENTION

Chemical vapor deposition (CVD) is a process whereby a film is deposited on a substrate by reacting chemicals together in the gaseous or vapor phase to form a film. The gases or vapors utilized for CVD are gases or compounds that contain the element to be deposited and that may be induced to react with a substrate or other gas(es) to deposit a film. The CVD reaction may be thermally activated, plasma induced, plasma enhanced or activated by light in photon induced systems.

CVD is used extensively in the semiconductor industry to build up wafers. CVD can also be used for coating larger substrates such as glass and polycarbonate sheets. Plasma enhanced CVD (PECVD), for example, is one of the more promising technologies for creating large photovoltaic sheets and polycarbonate windows for automobiles.

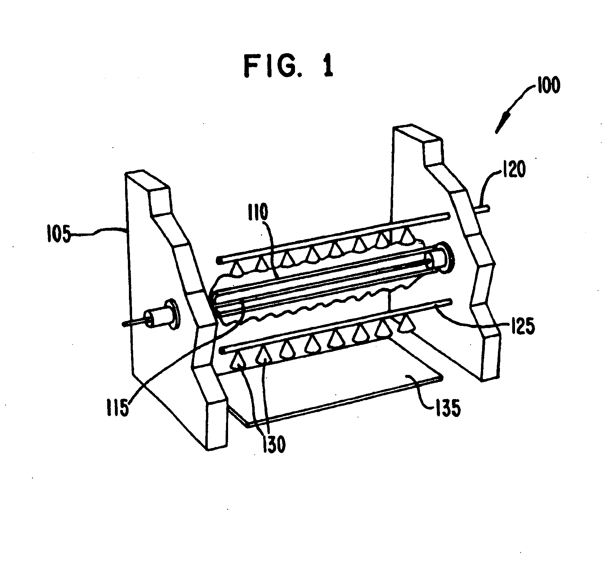

Figure 1 illustrates a cut away of a typical PECVD system 100 for large-scale deposition processes - currently up to 2.5 meters wide. This system includes a vacuum chamber 105 of which only two walls are illustrated. The vacuum chamber houses a linear discharge tube 110. The linear discharge tube 110 is formed of an inner conductor 115 that is configured to carry a microwave signal, or other signals, into the vacuum chamber 105. This microwave power radiates outward from the inner conductor 115 and ignites the surrounding support gas that is introduced through the support gas tube 120. This ignited gas is a plasma and is generally adjacent to the linear discharge tube 110. Radicals generated by the plasma and electromagnetic radiation disassociate the feedstock gas(es) 130 introduced through the feedstock gas tube 125 thereby breaking up the feedstock gas to form new molecules. Certain molecules formed during the disassociation process are deposited on the substrate 135. The other molecules formed by the disassociation process are waste and are removed through an exhaust port (not shown) - although these molecules tend to occasionally deposit themselves on the substrate.

To coat large substrate surface areas rapidly, a substrate carrier moves the substrate 135 through the vacuum chamber 105 at a steady rate. Other embodiments however, could include static coating. As the substrate 135 moves through the vacuum chamber 105, the disassociation should continue at a steady rate, and target molecules from the disassociated feed gas are theoretically deposited evenly on the substrate, thereby forming a uniform film on the substrate. But due to a variety of real-world factors, the films formed by this process are not always uniform. And often, efforts to compensate for these real-world factors damage the substrate by introducing too much heat or other stresses. Accordingly, an improved system and method are needed.

### SUMMARY OF THE INVENTION

Exemplary embodiments of the present invention that are shown in the drawings are summarized below. These and other embodiments are more fully described in the Detailed Description section. It is to be understood, however, that there is no intention to limit the invention to the forms described in this Summary of the Invention or in the Detailed Description. One skilled in the art can recognize that there are numerous modifications, equivalents and alternative constructions that fall within the spirit and scope of the invention as expressed in the claims.

One embodiment of the present invention is a system for depositing films on a substrate. This systems includes a vacuum chamber; a linear discharge tube housed inside the vacuum chamber; a magnetron configured to generate a VHF, microwave, or other high energy power signals that can be applied to the linear discharge tube; a power supply, which can include an electronic amplifier, configured to provide a power signal to the magnetron; and a pulse control connected to the power supply. The pulse control is configured to control the duty cycle of the plurality of pulses, the frequency of the plurality of pulses, and/or the contour shape of the plurality of pulse.

### BRIEF DESCRIPTION OF THE DRAWINGS

Various objects and advantages and a more complete understanding of the present invention are apparent and more readily appreciated by reference to the following Detailed Description and to the appended claims when taken in conjunction with the accompanying Drawing wherein:
FIGURE 1 is an illustration of an existing linear PECVD system;
FIGURE 2 is an illustration of a linear discharge tube with surrounding, irregular plasma;
FIGURE 3 is an illustration of a shielded split antennae arrangement for a linear discharge tube;
FIGURE 4 illustrates exemplary power source signals that can be used with the present invention;
FIGURE 5 is an illustration of a power source in accordance with one embodiment of the present invention; and
FIGURE 6 is an illustration of another power source in accordance with an embodiment of the present invention.

### DETAILED DESCRIPTION

As previously described, real-world factors act to limit the quality of films created by deposition systems, including linear microwave deposition systems. One of these limiting factors is an inability to create and maintain uniform plasmas around the linear discharge tube. Non-uniform plasmas result in non-uniform disassociation at certain points along the linear discharge tube, thereby causing non-homogenous deposition on certain portions of the substrate.

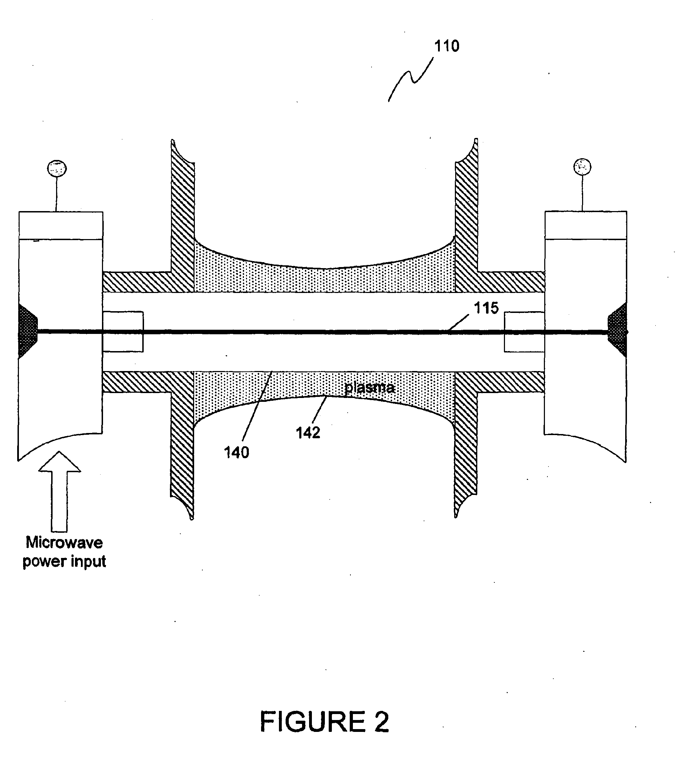

FIGURE 2 illustrates a non-uniform plasma formed along typical linear discharge tubes 110 used in microwave deposition systems. For perspective, this linear discharge tube 110 is located inside a vacuum chamber (not shown) and includes an inner conductor 115, such as an antenna, inside a non-conductive tube 140. Microwave power, or other energy waves, is introduced into the inner conductor 115 at both ends of the linear discharge tube 110. The microwave power ignites the gas near the linear discharge tube 110 and forms a plasma 142. But as the microwave power travels toward the center of the linear discharge tube 110, the amount of power available to ignite and maintain the plasma drops. In certain cases, the plasma 142 near the center of the linear discharge tube 110 may not ignite or may have an extremely low density compared to the plasma 142 at the ends of the linear discharge tube 110. Low power density results in low gas disassociation near the center of the linear discharge tube 110 and low deposition rates near the center of the substrate.

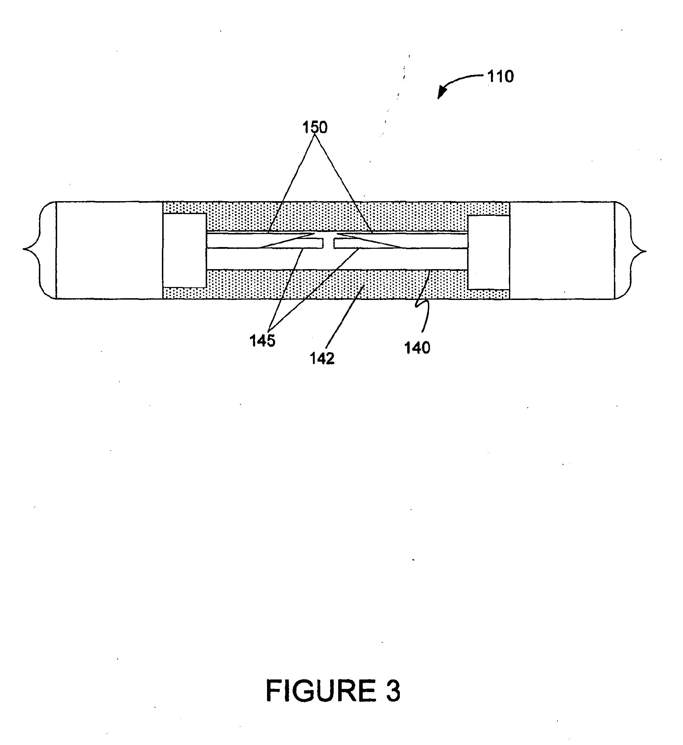

One system for addressing low plasma density near the center of the linear discharge tube 110 uses a split inner conductor. For example, two conductors are used inside the non-conductive tube. Another system, shown in Figure 3, uses two conductors 145, such as two antennas, and metal shielding 150 placed inside the non-conductive tube 140. The metal shielding 150 and the split antenna 145 act to control the energy discharge and generate a uniform plasma density 142.

Linear discharge systems are generally driven by a power system, which can include DC supplies and/or amplifiers, coupled to a magnetron. Further enhancements to power-density uniformity and plasma uniformity along the linear discharge tube can be realized by controlling this power system. For example, plasma uniformity along the linear discharge tube can be changed by controlling the following properties of a DC signal generated by one type of power system, a DC power system: DC pulse duty cycles, pulse frequencies, and/or signal modulation. Signal modulation includes modulation of amplitude or pulse amplitude, frequency, pulse position, pulse width, duty cycle or simultaneous amplitude and any of the frequency types of modulation. Signal modulation is discussed in commonly owned and assigned attorney docket number (APPL-007/00US corresponding to US Serial No. 11/264,596 and to reference No. P 1153-AFC/EP of the European representative), entitled SYSTEM AND METHOD FOR MODULATION OF POWER AND POWER RELATED FUNCTIONS OF PECVD DISCHARGE SOURCES TO ACHIEVE NEW FILM PROPERTIES, which is incorporated herein by reference.

Each of these changes directly changes the microwave power signal being introduced into the inner conductor of the linear discharge tube. Changes to the microwave power signal change the plasma uniformity around the linear discharge tube. And in many cases, changes to the DC power system can be used to control the plasma properties to thereby increase the uniformity of a chemical make up of the film. These enhancements to the power supply can be applied to single antenna systems, multiple antenna systems, multiple antenna systems with shields, etc.

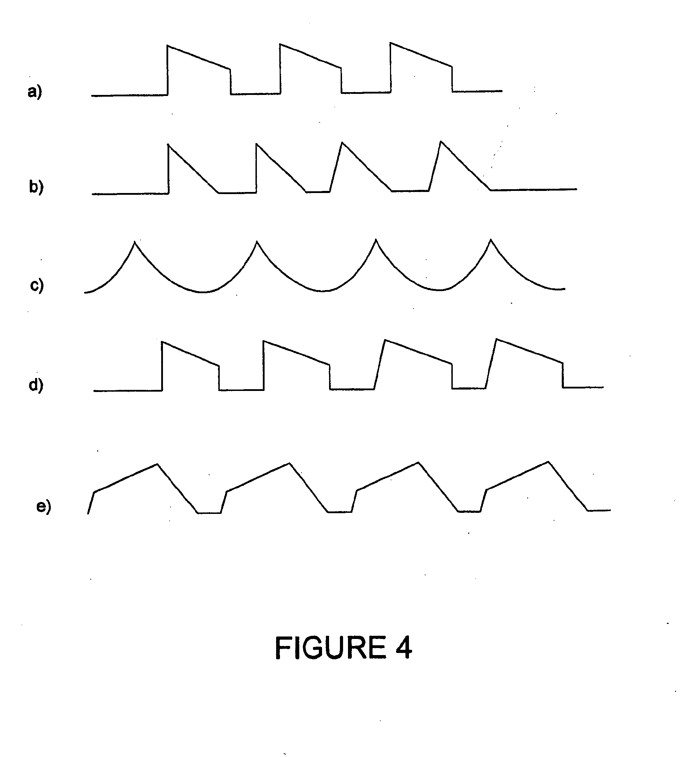

Even further enhancements to a deposition system can be realized by contouring the power density in the linear discharge tube. The power density can be contoured by contouring the power signal being introduced into the inner conductor. One method of contouring the power signal being introduced into the inner conductor involves contouring the output of the DC power system. For example, the individual pulses of the DC power system can be contoured. Figure 4 illustrates five exemplary contoured pulses that can be used to contour the power density in a linear discharge tube. The duty cycle, frequency, amplitude, etc. of this signal can also be adjusted. The signal can also be modulated.

Particularly good results are anticipated when the degrading-pulse contours shown in Figures 4a, 4b, 4c and 4d are used. This degrading pulse helps maintain a uniform power density along the entire length of the linear discharge tube as the plasma ignition travels from the outer edges toward the center of the linear discharge tube. These enhancements can be applied to single antenna systems, dual antenna systems, dual antenna systems with shields, etc. These enhancements can also be used to evenly coat curved substrates as well as flat substrates because of the control of local densities.

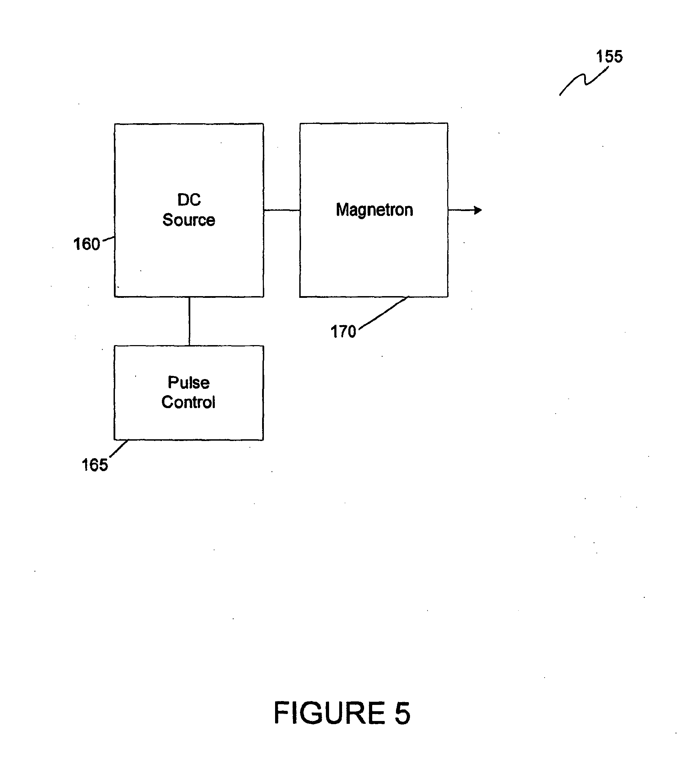

Figure 5 illustrates a system constructed in accordance with one embodiment of the present invention. This system includes a DC source 160 that is controllable by the pulse control 165. The DC source powers the magnetron 170, which generates the microwaves (or other waves) that drive the inner conductor within the linear discharge tube. The pulse control 165 can contour the shape of the DC pulses and adjust pulse properties such as duty cycle, frequency, and amplitude.

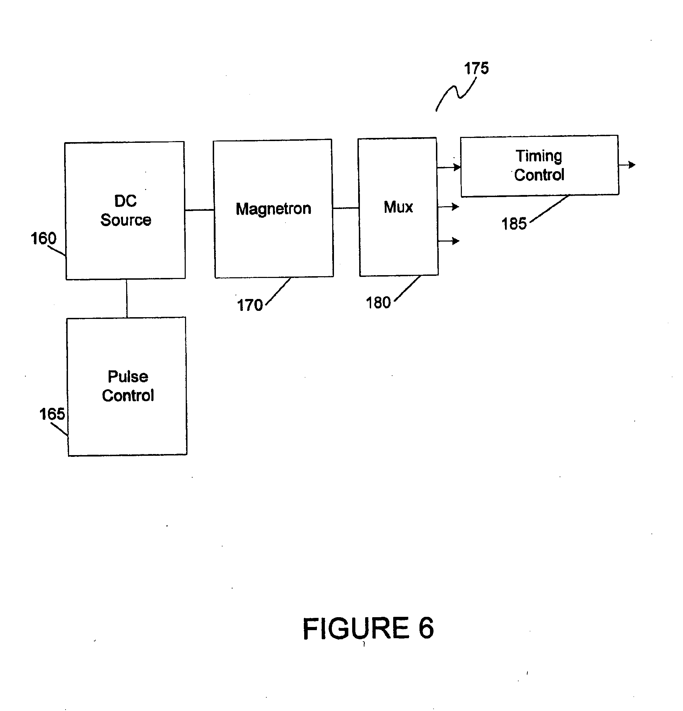

Referring now to Figure 6, it illustrates another embodiment of a system 170 constructed in accordance with the principles of the present invention. This system includes the DC source 160 with pulse control 165 and the magnetron 170 also shown in Figure 5. This system additionally includes a multiplexer 180 and a timing control system 185. The multiplexer 180 is responsible for dividing the output of the magnetron into several signals. Each signal can then be used to power a separate linear discharge tube or separate antenna within a single linear discharge tube.

Recall that most linear discharge deposition systems include several linear discharge tubes. In certain instances, it may be desirable to offset the timing of the pulses driving adjacent linear discharge tubes. The microwaves generated by one linear discharge tube can travel to adjacent linear discharge tubes and impact power density and plasma uniformity. With proper timing control, that impact can be positive and can assist with maintaining a uniform power density and plasma. The timing control 185 can provide this timing control. These of skill in the art would understand how to tune the timing control.

The timing control 185 can also be used with linear discharge systems that include multiple magnetrons 170 and/or DC sources 160. In these systems, each linear discharge tube is driven by a separate magnetron and possibly a separate DC source. The timing control can be applied to each magnetron and/or each DC source. The terms "DC source" and "DC power supply" refer to any type of power system, including those that use a linear amplifier, a non-linear amplifier, or no amplifier. The terms can also refer to an amplifier by itself.

In conclusion, the present invention provides, among other things, a system and method for controlling deposition onto substrates. Those skilled in the art can readily recognize that numerous variations and substitutions may be made in the invention, its use and its configuration to achieve substantially the same results as achieved by the embodiments described herein. Accordingly, there is no intention to limit the invention to the disclosed exemplary forms. Many variations, modifications and alternative constructions fall within the scope and spirit of the disclosed invention as expressed in the claims.

## Claims

1. A system for depositing films on a substrate, the system comprising:
a vacuum chamber;
a linear discharge tube housed inside the vacuum chamber;
a magnetron configured to generate a microwave power signal that can be applied to the linear discharge tube;
a power supply configured to provide a power signal to the magnetron, the DC power signal including a plurality of pulses; and
a pulse control connected to the power supply, the pulse control configured to control the duty cycle of the plurality of pulses, the frequency of the plurality of pulses, and the contour shape of the plurality of pulses.

2. The system of claim 1, wherein the pulse control is configured to decrease or increase the power of one of the plurality of pulses.

3. The system of claim 1, wherein the linear discharge tube is a first linear discharge tube, the system further comprising:
a second linear discharge tube; and
a multiplexer connected to the first linear discharge tube, the second linear discharge tube, and the magnetron.

4. The system of claim 1, wherein the linear discharge tube comprises:
a non-conductive outer layer,
two inner conductors located inside the non-conductive outer layer; and
a metal shield located adjacent to the two inner conductors and the non-conductive outer layer.

5. A power system for film deposition, the system comprising:
a magnetron configured to generate a microwave power signal for driving a linear discharge tube in a film deposition system;
a power source connected to the magnetron, the power source configured to generate a plurality of pulses; and
a control system connected to the power source, the control system configured to control the contour shape of the plurality of pulses to thereby control the output of the magnetron and the operation of the linear discharge tube in the film deposition system.

6. The system of claim 5, wherein the control system is further configured to control the duty cycle of the plurality of pulses to thereby control the output of the magnetron and the operation of the linear discharge tube in the film deposition system.

7. The system of claim 5, wherein the control system is further configured to control the frequency of the plurality of pulses to thereby control the output of the magnetron and the operation of the linear discharge tube in the film deposition system.

8. A method to deposit films on a substrate, the method comprising:
generating a DC pulse with a contoured shape;
generating a microwave power signal using the contoured DC pulse;
providing the generated microwave power signal to a linear discharge tube located in a film deposition system;
generating a plasma at the linear discharge tube using the generated microwave power signal;
disassociating a gas using the generated plasma; and
depositing a portion of the disassociated gas onto a substrate.

9. A power system for film deposition, the system comprising:
a magnetron configured to generate a microwave power signal that can be applied to the linear discharge tube;
an amplifier configured to provide a DC signal to the magnetron, the DC signal including a plurality of pulses; and
a pulse control connected to the amplifier, the pulse control configured to control the duty cycle of the plurality of pulses, the frequency of the plurality of pulses, and the contour shape of the plurality of pulses.

10. The system of claim 9, wherein the amplifier is a linear amplifier.

11. The system of claim 9, wherein the amplifier is a non-linear amplifier.

12. The system of claim 9, further comprising a multiplexer connected to the output of the magnetron.

13. The system of claim 9, wherein the pulse control is configured to contour the shape of one of the plurality of pulses so that the power of the one of the plurality of pulses decreases from an initial power point for the one of the plurality of pulses.

14. The system of claim 9, wherein the pulse control is configured to contour the shape of one of the plurality of pulses so that the power of the one of the plurality of pulses increases from an initial power point for the one of the plurality of pulses.
